# EUROPÄISCHE PATENTSCHRIFT

(11) **EP 1 762 634 B1**
(45) Veröffentlichungstag und Bekanntmachung des Hinweises auf die Patenterteilung: **11.03.2009**
(21) Anmeldenummer: 05019785.4
(22) Anmeldetag: 12.09.2005
(51) Int. Cl.: C23C 14/24, C23C 14/50, C23C 14/54

(54) **Verfahren zum Beschichten einer Turbinenschaufel**
Method for coating a turbine blade
Procédé de revêtement d'une aube de turbine

(43) Veröffentlichungstag der Anmeldung: 14.03.2007
(73) Patentinhaber: SIEMENS AKTIENGESELLSCHAFT, 80333 München (DE)
(72) Erfinder: Berndt, Thomas, 12524 Berlin (DE); Reymann, Helge, 14167 Berlin (DE)

(56) Entgegenhaltungen:
- DE-A1- 2 821 118
- US-A- 3 560 252
- US-A- 4 676 994
- US-A- 5 876 860
- US-A1- 2004 065 262

## Beschreibung

Die Erfindung betrifft ein Verfahren zum Beschichten einer Turbinenschaufel mittels Abscheidung aus der Gasphase, bei der das Beschichtungsmaterial aus einer Schmelze verdampft wird. Insbesondere betrifft die Erfindung ein derartiges Verfahren, in welchem eine Turbinenschaufel mit einer keramischen Beschichtung versehen wird.

Turbinenbauteile; beispielsweise Turbinenschaufeln von Gasturbinen, werden häufig mit wärmedämmenden Keramikbeschichtungen versehen, um ihre Widerstandsfähigkeit gegen die in einer Gasturbinenanlage auftretenden Temperaturen zu erhöhen. Als eine derartige Wärmedämmbeschichtung (TBC, Thermal Barrier Coating) kann beispielsweise eine Zirkonoxid-Schicht (ZiO₂-Schicht) aufgebracht werden, die mit Yttriumoxid (Y₂O₃) zumindest teilstabilisiert ist.

Das Aufbringen einer auf Zirkonoxid basierenden Wärmedämmbeschichtung auf eine Turbinenschaufel ist beispielsweise in US 4,676,994 beschrieben. Darin wird die Beschichtung mittels physikalischer Abscheidung aus der Gasphase (PVD, Physical Vapor Deposition) auf ein Turbinenbauteil aufgebracht. In einer Vakuumkammer wird in einem Tiegel eine Schmelze des Keramikmaterials so weit erhitzt, dass ein rascher Verdampfungsprozess eintritt. Verdampfte Keramikmoleküle lagern sich dabei auf der Oberfläche des zu beschichtenden Bauteils ab. Damit eine gleichmäßige Beschichtung auf der gesamten Oberfläche erzielt wird, wird das Bauteil während der Beschichtung kontinuierlich mit einer festen Winkelgeschwindigkeit gedreht. Dadurch wird sichergestellt, dass alle Umfangsbereiche des Bauteils in regelmäßigen Abständen dem Tiegel mit der Schmelze zugewandt sind.

Dokument DE 28 21 118 A1 offenbart ein Verfahren zum allseitigen Bedampfen von gekrümmten Turbinenschaufeln mit Anström- und Abströmkanten sowie mit einer konkaven und einer konvexen Schaufelflanke mit korrosions- und oxydationbeständigen Legierungsschichten im Vakuum bei gleichzeitiger Drehung der Turbinenschaufeln im Dampfstrom oberhalb einer Verdampfquelle um ihre Längsachse, so daß die Verweilzeit eines jeden Flächenelements oberhalb der Verdampfquelle während einer Drehung von 360° in der Weise verändert wird, daß sie bei einer Ausrichtung der Anström- und Abströmkanten auf die Verdampfquelle am kleinsten und bei einer Ausrichtung der konkaven und der konvexen Flanken am größten ist; wobei die Verweilzeit etwa im mitteleren Bereich der konkaven Flanke gegenüber der Verweilzeit im mitteleren Bereich der konvexen Flanke mindestens um den Faktor 4, vorzugweise um mindestens den Faktor 4 größer ist, und die Verweilzeit am längsten gehalten wird, während die Winkelhalbierende zwischen Anströmwinkel und Abströmwinkel auf die Verdampfquelle ausgerichtet ist, und die Verweilzeit dann im Bereich der kleinsten Verweilzeiten gehalten wird, wenn der Teil der konvexen Flanke mit dem größten Krümmungsradius etwa parallel zur Dampfstrahleinrichtung ausgerichtet ist. Die Anzahl von Winkelsektoren ist 36 ist, d.h. je 10 Grad.

Aufgabe der vorliegenden Erfindung ist es, ein gegenüber diesem Stand der Technik verbessertes Verfahren zum Beschichten einer Turbinenschaufel zur Verfügung zu stellen.

Diese Aufgabe wird durch ein Verfahren nach Anspruch 1 gelöst. Die abhängigen Ansprüche enthalten vorteilhafte Ausgestaltungen der Erfindung.

Im erfindungsgemäßen Verfahren zum Beschichten einer Turbinenschaufel erfolgt ein Abscheiden des Beschichtungsmaterials aus der Gasphase. Dabei wird das Beschichtungsmaterial aus einer Schmelze in eine Verdampfungsrichtung verdampft. Unter Verdampfungsrichtung soll hierbei diejenige Richtung zu verstehen sein, in der die Impulsverteilung der Moleküle des verdampften Beschichtungsmaterials ihr Maximum aufweist. Das zu beschichtende Bauteil erfährt während des Beschichtens eine Rotation um eine Rotationsachse, die senkrecht oder nahezu senkrecht zur Verdampfungsrichtung verläuft. Im erfindungsgemäßen Verfahren wird die Rotationsgeschwindigkeit des Bauteils um die Rotationsachse während einer Rotationsperiode variiert.

Die Variation der Rotationsgeschwindigkeit während einer Rotationsperiode ermöglicht es, die Geometrie des Bauteils beim Beschichten zu berücksichtigen und die Winkelgeschwindigkeit in Abhängigkeit von der Form des Bauteils, insbesondere in einem Schnitt quer zur Rotationsachse, zu variieren.

Dies ermöglicht einerseits, bei einem Bauteil mit einem regelmäßigen Querschnitt bezüglich der Rotationsachse, beispielsweise einem runden Querschnitt, Beschichtungen mit einer über dem Umfang variierenden Dicke herzustellen. Insbesondere ermöglicht das Verfahren aber das Herstellen einer gleichmäßigen Beschichtung bei Bauteilen, deren Querschnitt einen Krümmungsradius aufweist, welcher entlang des Umfangs der Querschnittsfläche variiert. Um bei einem derartigen Bauteil eine gleichmäßige Beschichtung zu erzielen, erfolgt die Rotation mit einer relativ hohen Winkelgeschwindigkeit, wenn der Schmelze ein Bereich des Umfangs des Bauteils mit relativ großem Krümmungsradius zugewandt ist. Andererseits erfolgt die Rotation mit einer relativ niedrigen Winkelgeschwindigkeit, wenn der Schmelze ein Bereich des Umfangs des Bauteils mit relativ kleinem Krümmungsradius zugewandt ist. Auf diese Weise kann sichergestellt werden, dass in Bereichen mit kleinem Krümmungsradius und Bereichen mit großem Krümmungsradius dieselbe Schichtdicke erzielt werden kann.

Die Variation der Winkelgeschwindigkeit über eine Rotationsperiode wird schrittweise, also in bestimmten Winkelabständen erfolgen, beispielsweise alle 15°.

Das erfindungsgemäße Verfahren wird zum Beschichten einer Turbinenschaufel, insbesondere mit einer keramischen Beschichtung, insbesondere einer keramischen Wärmedämmschicht, ausgebildet sein.

Weitere Merkmale, Eigenschaften und Vorteile der vorliegenden Erfindung ergeben sich aus der nachfolgenden Beschreibung eines Ausführungsbeispiels unter Bezugaufnahme auf die beiliegenden Figuren.
Fig. 1 zeigt beispielhaft eine Gasturbine in einem Längsteilschnitt.
Fig. 2 zeigt in perspektivischer Ansicht eine Laufschaufel oder Leitschaufel einer Strömungsmaschine.
Fig. 3 zeigt eine Brennkammer einer Gasturbine
Figur 4 zeigt eine Turbinenschaufel während eines Beschichtungsprozesses in einer stark schematisierten Darstellung.
Fig. 5 zeigt die Zuordnung von Winkelsektoren, denen jeweils eine bestimmte Winkelgeschwindigkeit zuordenbar ist, in Bezug auf eine zu beschichtende Turbinenschaufel.
Figur 6 zeigt ein Beispiel für den Verlauf der Winkelgeschwindigkeit über eine Rotationsperiode.

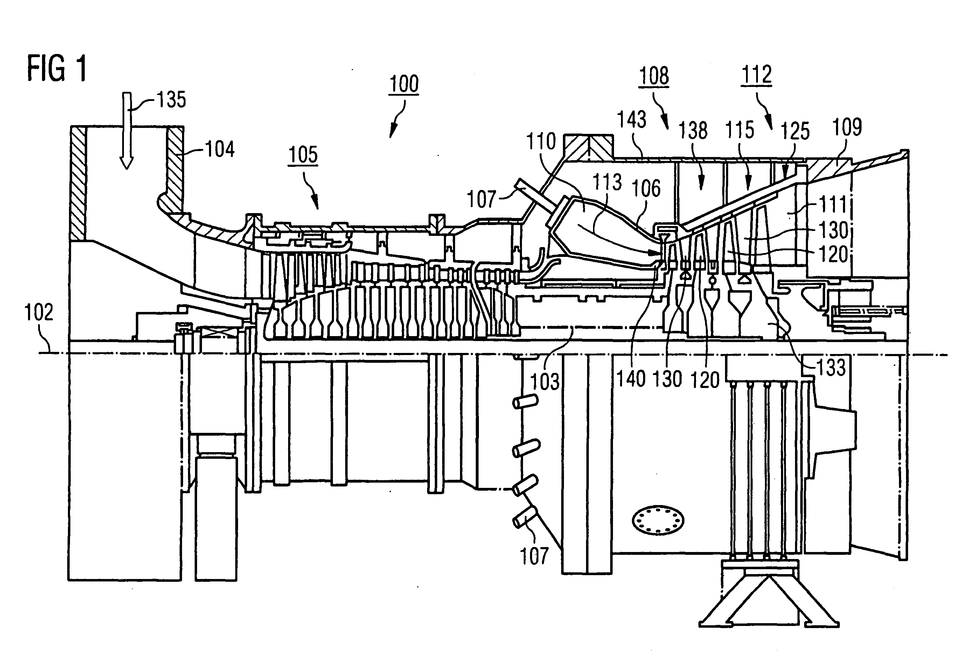

Die Figur 1 zeigt beispielhaft eine Gasturbine 100 in einem Längsteilschnitt. Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109.

Die Ringbrennkammer 106 kommuniziert mit einem beispielsweise ringförmigen Heißgaskanal 111. Dort bilden beispielsweise vier hintereinander geschaltete Turbinenstufen 112 die Turbine 108.

Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.

An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet.

Um den dort herrschenden Temperaturen standzuhalten, können diese mittels eines Kühlmittels gekühlt werden.

Ebenso können Substrate der Bauteile eine gerichtete Struktur aufweisen, d.h. sie sind einkristallin (SX-Struktur) oder weisen nur längsgerichtete Körner auf (DS-Struktur).

Als Material für die Bauteile, insbesondere für die Turbinenschaufel 120, 130 und Bauteile der Brennkammer 110 werden beispielsweise eisen-, nickel- oder kobaltbasierte Superlegierungen verwendet. Solche Superlegierungen sind beispielsweise aus der EP 1204776 B1, EP 1306454, EP 1319729 A1, WO 99/67435 oder WO 00/44949 bekannt.

Ebenso können die Schaufeln 120, 130 Beschichtungen gegen Korrosion (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein, und besteht beispielsweise aus ZrO₂, Y₂O₄-ZrO₂, d.h. sie ist nicht, teilweise oder vollständig stabilisiert durch Yttriumoxid und/oder Kalziumoxid und/oder Magnesiumoxid. Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

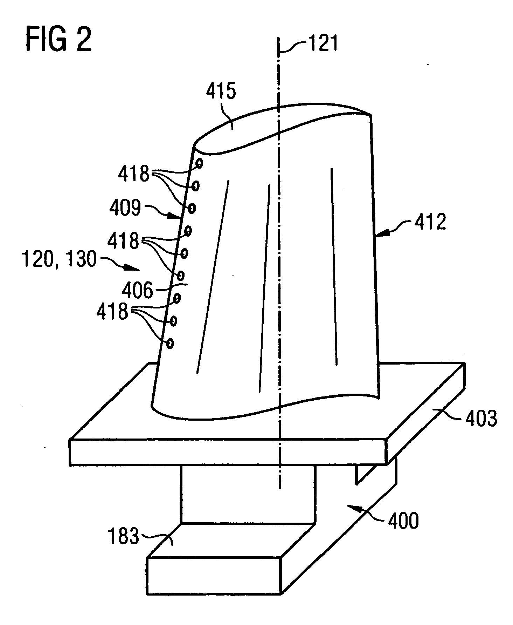

Figur 2 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf. Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.

Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet. Solche Superlegierungen sind beispielsweise aus der EP 1204776 B1, EP 1306454, EP 1319729 A1, WO 99/67435 oder WO 00/44949 bekannt. Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind. Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt. Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen. Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt.

Ebenso können die Schaufeln 120, 130 Beschichtungen gegen Korrosion oder Oxidation (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Auf der MCrAlX kann noch eine Wärmedämmschicht vorhanden sein und besteht beispielsweise aus ZrO₂, Y₂O₄-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions-und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

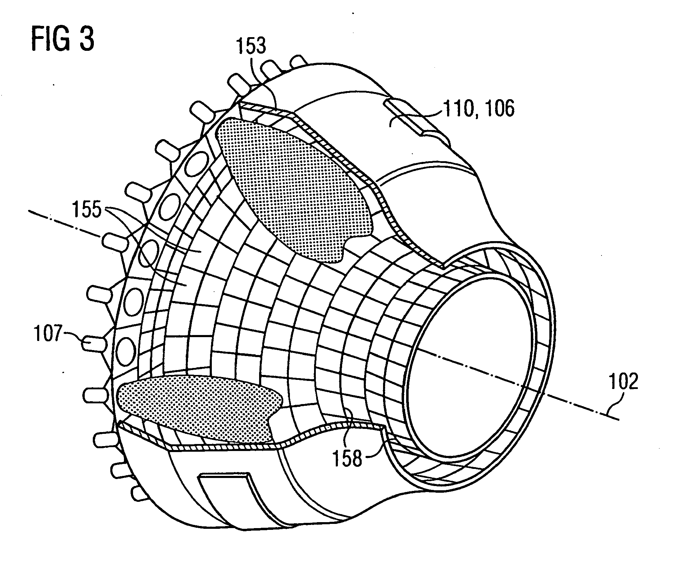

Die Figur 3 zeigt eine Brennkammer 110 einer Gasturbine. Die Brennkammer 110 ist beispielsweise als so genannte Ringbrennkammer ausgestaltet, bei der eine Vielzahl von in Umfangsrichtung um die Rotationsachse 102 herum angeordneten Brennern 107 in einen gemeinsamen Brennkammerraum münden. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 ist arbeitsmediumsseitig mit einer besonders hitzebeständigen Schutzschicht ausgestattet oder aus hochtemperaturbeständigem Material gefertigt. Dies können massive keramische Steine oder Legierungen mit MCrAlX und/oder keramischen Beschichtungen sein. Die Materialien der Brennkammerwand und deren Beschichtungen können ähnlich der Turbinenschaufeln sein.

Aufgrund der hohen Temperaturen im Inneren der Brennkammer 110 kann zudem für die Hitzeschildelemente 155 bzw. für deren Halteelemente ein Kühlsystem vorgesehen sein.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

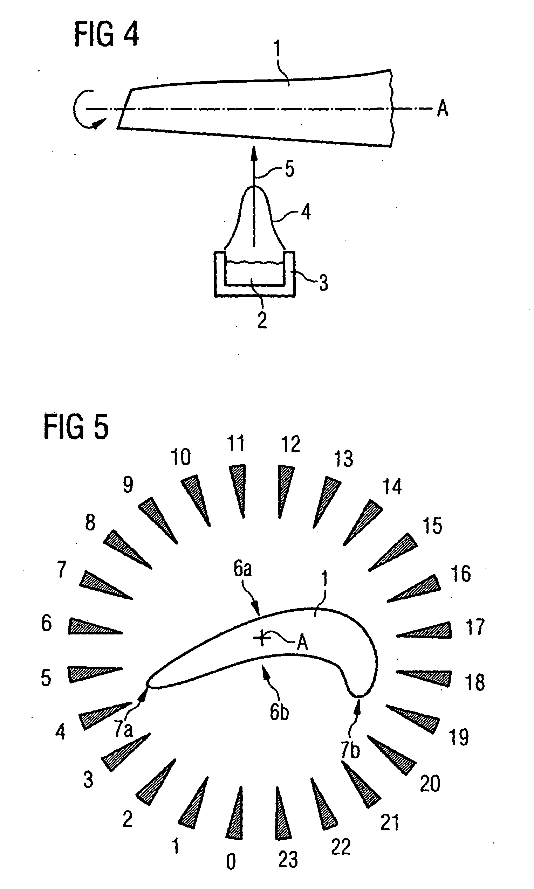

Ein Ausführungsbeispiel für das erfindungsgemäße Verfahren zum Beschichten eines Bauteils wird nachfolgend mit Bezug auf die Figuren 4 bis 6 beschrieben. Im Ausführungsbeispiel ist eine Turbinenschaufel, die aufzubringende Schicht eine keramische Wärmedämmschicht. Die keramische Wärmedämmschicht ist als yttriumstabilisierte Zirkonoxid-Schicht (ZrO₂-Schicht) ausgebildet.

Bevor die Wärmedämmschicht mittels eines physikalischen Abscheideverfahrens aus der Gasphase aufgebracht wird, erfolgt ein Vorbehandeln der zu beschichtenden Turbinenschaufel 1. Das Vorbehandeln der Turbinenschaufel umfasst das Herstellen einer Aluminiumoxid (Al₂O₃) bildenden Schicht und einen Vorheizprozess, indem ein teilweises Umwandeln der Aluminiumoxid bildenden Schicht in Aluminiumoxid sowie ein Reinigen der Turbinenschaufel 1 erfolgt.

Im vorliegenden Ausführungsbeispiel ist diese Aluminiumoxid bildende Schicht eine MCrAlX-Schicht. Alternativ kann jedoch auch eine Aluminiumschicht aufgebracht werden. Das Aufbringen dieser Schicht kann beispielsweise mittels physikalischer Abscheidung aus der Gasphase erfolgen, gefolgt von einem Kugelstrahlen der mit der Aluminiumoxid bildenden Beschichtung versehenen Turbinenschaufel.

Zum Durchführen des Vorheizprozesses wird die mit der MCrAlX-Schicht versehene Turbinenschaufel 1 in eine Vakuumkammer eingebracht, die auf einen Druck von etwa 0.133 Pa (10⁻³ Torr) evakuiert wird. Mittels Strahlungsheizung oder Elektronenstrahlheizung wird die Turbinenschaufel 1 auf eine Temperatur zwischen 870°C und 1100°C vorgeheizt und auf dieser Temperatur für 10 bis 30 Minuten gehalten. Dies führt zu einem Entgasen des Oberflächenmaterials sowie zu einem Trocknen und Reinigen der Oberfläche durch Verdampfung von Rückständen. Außerdem bildet sich während dieses Vorheizens die Aluminiumoxidschicht, auf die später die keramische Wärmedämmschicht aufgebracht wird.

Nachdem das Vorheizen abgeschlossen ist, wird die Turbinenschaufel 1 zum Beschichten mit der keramischen Wärmedämmschicht in eine andere Vakuumkammer überführt. In dieser wird eine Schmelze 2 des keramischen Beschichtungsmaterials in einem Tiegel 3 so weit erhitzt, dass das Beschichtungsmaterial rasch verdampft (vgl. Fig. 4). Wenn das Material der keramischen Wärmedämmschicht beispielsweise ZrO₂ (Zirkonoxid) ist, welches mit 20 Gew.-% Y₂O₃ (Yttriumoxid) stabilisiert ist, liegt diese Temperatur etwa zwischen 1800 und 2000°C. Das rasche Verdampfen führt dazu, dass sich Moleküle des Beschichtungsmaterials von der Oberfläche der Schmelze 2 wegbewegen. Die sich wegbewegenden Moleküle weisen dabei eine Geschwindigkeitsverteilung 4 auf, die in eine Richtung 5 ein Maximum aufweist. In dieser Richtung 5 ist die Turbinenschaufel 1 mit einem bestimmten Abstand von dem Tiegel 3 angeordnet.

Damit die Turbinenschaufel 1 über den gesamten Umfang beschichtet wird, rotiert sie während des Beschichtungsprozesses um eine Rotationsachse A, welche senkrecht zur Richtung 5 des Geschwindigkeitsmaximums, im Folgenden Verdampfungsrichtung genannt, verläuft. Dabei ist die Ablagerungsrate auf einem bestimmten Oberflächenabschnitt hoch, wenn dessen Oberflächennormale während der Rotation relativ lange einen kleinen Winkel mit der Verdampfungsrichtung 5 einschließt. Schließt die Oberflächennormale dagegen einen großen Winkel mit der Verdampfungsrichtung 5 ein, so ist die Ablagerungsrate auf den zugehörigen Oberflächenabschnitt relativ gering.

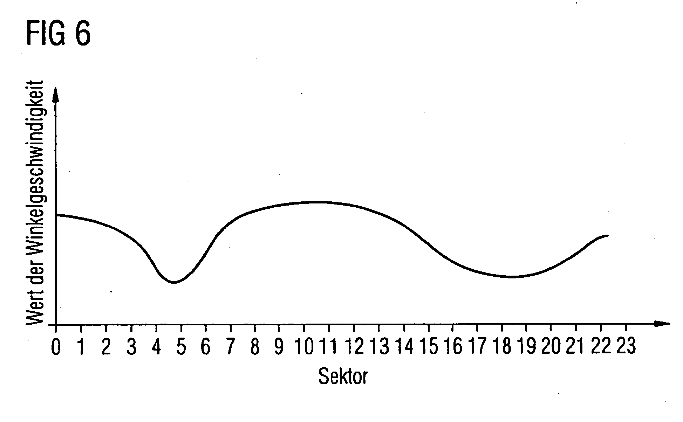

Betrachtet man einen Querschnitt der Turbinenschaufel 1 senkrecht zur Rotationsachse A (Fig. 5), so ist zu erkennen, dass sie Umfangsabschnitte 6a, 6b mit einem relativ großen Krümmungsradius und Umfangsabschnitte 7a, 7b mit einem relativ kleinen Krümmungsradius aufweist. Wenn nun eine Rotation mit einer gleichmäßigen Winkelgeschwindigkeit erfolgt, so gilt für Oberflächenabschnitte in Bereichen mit einem großen Krümmungsradius, dass die Normalen dieser Oberflächenbereiche relativ lange einen kleinen Winkel mit der Verdampfungsrichtung einschließen, wohingegen für Oberflächenabschnitte in Bereichen mit einem kleinen Krümmungsradius gilt, dass ihre Oberflächennormalen nur über eine vergleichsweise kurze Zeitdauer einen relativ kleinen Winkel mit der Verdampfungsrichtung einschließen. Dies hat zur Folge, dass bei einer Rotation mit einer gleichmäßigen Winkelgeschwindigkeit in Bereichen mit großem Krümmungsradius die Beschichtung eine größere Dicke aufweisen wird als in Bereichen mit einem relativ geringen Krümmungsradius. Um diesen geometrischen Effekt auszugleichen, erfolgt die Rotation im erfindungsgemäßen Verfahren nicht mit einer gleichförmigen Winkelgeschwindigkeit, sondern wird in Abhängigkeit von der Geometrie des Querschnittes der Turbinenschaufel 1 senkrecht zur Rotationsachse A variiert. Insbesondere wird die Winkelgeschwindigkeit erhöht, wenn dem Tiegel 3 ein Abschnitt 6a, 6b mit relativ großem Krümmungsradius zugewandt ist, und die Winkelgeschwindigkeit herabgesetzt, wenn dem Tiegel ein Abschnitt 7a, 7b mit relativ kleinem Krümmungsradius zugewandt ist. Auf diese Weise lässt sich eine gleichmäßige Beschichtung über den gesamten Umfang der Turbinenschaufel 1 aufbringen. Ein typischer Verlauf der Winkelgeschwindigkeit über eine Rotationsperiode der Turbinenschaufel ist in Figur 6 dargestellt.

Die Winkelgeschwindigkeit, mit der die Turbinenschaufel 1 während des Abscheidens aus der Gasphase rotiert,wird schrittweise variiert.

Bei der schrittweisen Variation werden dem Schaufelquerschnitt der Turbinenschaufel 1 wie in Figur 5 dargestellt Winkelsektoren zugeordnet. Im vorliegenden Ausführungsbeispiel sind dem Querschnitt 24 Winkelsektoren zu je 15° zugeordnet. Diese Sektoren sind in Figur 5 mit den Ziffern 0 bis 23 bezeichnet. Je nachdem, welcher Sektor dem Tiegel 3 zugewandt ist, wird ein anderer Wert für die Winkelgeschwindigkeit eingestellt. Die Winkelgeschwindigkeit wird dann so lange konstant gehalten, bis bei der Rotation der nächste Sektor dem Tiegel 3 zugewandt ist. Sobald dies der Fall ist, wird der nächste Wert für die Winkelgeschwindigkeit eingestellt. Es sei an dieser Stelle angemerkt, dass die Einteilung in 24 Winkelsektoren völlig willkürlich ist. Der erfindungsgemäße Effekt wird umso schlechter erzielt, je weniger Winkelsektoren vorhanden sind, da dann die Werte der Winkelgeschwindigkeit weniger genau an den Querschnitt der Turbinenschaufel 1 relativ zur Rotationsachse A anpassbar sind. Erfindungsgemäß liegtdaher die Zahl der Winkelsektoren zwischen 15 und 36 .

Insgesamt sollte im erfindungsgemäßen Verfahren die durchschnittliche Winkelgeschwindigkeit über eine Rotationsperiode gemittelt zwischen einigen wenigen Umdrehungen pro Minute und einigen Dutzend Umdrehungen pro Minute liegen.

Die Temperatur der Turbinenschaufel 1 während des Beschichtungsprozesses wird auf 900°C bis 1200°C gehalten. Der Druck in der Vakuumkammer beträgt vorzugsweise nicht mehr als 0.0133 Pa (10⁻⁴ Torr).

Nach dem Abscheiden der keramischen Wärmedämmschicht kann die Turbinenschaufel 1 noch einer Wärmebehandlung ausgesetzt werden, um die gewünschte Struktur der keramischen Wärmedämmschicht zu erzeugen.

## Patentansprüche

1. Verfahren zum Beschichten einer Turbinenschaufel (1) mittels Abscheidung des Beschichtungsmaterials aus der Gasphase,
wobei das Beschichtungsmaterial aus einem Tiegel (3) mit einer Schmelze (2) in eine Verdampfungsrichtung (5) verdampft wird,
in welchem die zu beschichtende Turbinenschaufel (1) während des Beschichtens eine Rotation um eine Rotationsachse (A) erfährt,
die senkrecht oder nahezu senkrecht zur Verdampfungsrichtung (5) verläuft,
wobei die Winkelgeschwindigkeit der Rotation während einer Rotationsperiode variiert,
die Änderung der Winkelgeschwindigkeit schrittweise in bestimmten Winkelabständen erfolgt,
wobei die Anzahl von Winkelsektoren zwischen 15 und 36 liegt,
**dadurch gekennzeichnet, dass** je nachdem welcher Sektor dem Tiegel (3) zugewandt ist, ein anderer Wert für die Winkelgeschwindigkeit eingestellt wird.

2. Verfahren nach Anspruch 1,
**dadurch gekennzeichnet, dass**
die Variation der Winkelgeschwindigkeit in Abhängigkeit von der Form der Turbinenschaufel (1) in einem Schnitt quer zur Rotationsachse (A) erfolgt.

3. Verfahren nach Anspruch 2,
**dadurch gekennzeichnet, dass**
die Winkelgeschwindigkeit relativ hoch ist, wenn der Schmelze (2) ein Bereich (6a, 6b) der
Turbinenschaufel (1) mit relativ großem Krümmungsradius zugewandt ist,
und die Winkelgeschwindigkeit relativ niedrig ist, wenn der Schmelze (2) ein Bereich (7a, 7b) der Turbinenschaufel (1) mit relativ kleinem Krümmungsradius zugewandt ist.

4. Verfahren nach einem der vorangehenden Ansprüche,
**dadurch gekennzeichnet, dass**
als Beschichtung eine keramische Beschichtung aufgebracht wird.

5. Verfahren nach Anspruch 4,
**dadurch gekennzeichnet, dass**
die keramische Beschichtung eine Wärmedämmschicht ist.

## Claims

1. Method for coating a turbine blade (1) by means of vapour deposition of the coating material,
the coating material being vaporized from a crucible (3) with a melt (2) in a direction of vaporization (5),
in which, during the coating, the turbine blade (1) to be coated undergoes a rotation about an axis of rotation (A),
which extends perpendicularly or virtually perpendicularly in relation to the direction of vaporization (5),
the angular velocity of the rotation varying during a period of rotation,
the variation in the angular velocity taking place step by step in certain angular increments,
the number of angular sectors lying between 15 and 36,
**characterized in that,** depending on which sector is facing the crucible (3), a different value is set for the angular velocity.

2. Method according to Claim 1, **characterized in that** the variation in the angular velocity takes place in dependence on the form of the turbine blade (1) in a section transverse in relation to the axis of rotation (A).

3. Method according to Claim 2, **characterized in that** the angular velocity is relatively high when a region (6a, 6b) of the turbine blade (1) with a relatively great radius of curvature is facing the melt (2), and the angular velocity is relatively low when a region (7a, 7b) of the turbine blade (1) with a relatively small radius of curvature is facing the melt (2).

4. Method according to one of the preceding claims, **characterized in that** a ceramic coating is applied as the coating.

5. Method according to Claim 4, **characterized in that** the ceramic coating is a thermal barrier coating.

## Revendications

1. Procédé de revêtement d'une aube ( 1 ) de turbine au moyen d'un dépôt de la matière de revêtement en phase gazeuse, la matière de revêtement étant évaporée suivant une direction ( 5 ) d'évaporation, à partir d'un creuset ( 3 ) ayant une masse ( 2 ) fondue,
dans lequel l'aube ( 1 ) de turbine à revêtir subit pendant le revêtement une rotation autour d'un axe ( A ) de rotation,
qui est perpendiculaire ou à peu près perpendiculaire à la direction ( 5 ) d'évaporation,
la vitesse angulaire de la rotation variant pendant une période de rotation,
la modification de la vitesse angulaire s'effectuant pas à pas à des intervalles angulaires déterminés,
le nombre des secteurs angulaires étant compris entre 15 et 36,
**caractérisé en ce que,** suivant le secteur qui est tourné vers le creuset ( 3 ), on règle une valeur autre de la vitesse angulaire.

2. Procédé suivant la revendication 1,
**caractérisé en ce qu'**on effectue la variation de la vitesse angulaire en fonction de la forme de l'aube ( 1 ) de la turbine dans une coupe transversalement à l'axe de rotation.

3. Procédé suivant la revendication 2,
**caractérisé en ce que** la vitesse angulaire est relativement grande,
lorsqu'une partie ( 6a,6b ) de l'aube ( 1 ) de la turbine ayant un rayon de courbure relativement grand est tournée vers la masse ( 2 ) fondue,
et la vitesse angulaire est relativement petite,
lorsqu'une partie ( 7a,7b ) de l'aube ( 1 ) de la turbine de rayon de courbure relativement petit est tournée vers la masse ( 2 ) fondue.

4. Procédé suivant l'une des revendications suivantes,
**caractérisé en ce que** on dépose comme revêtement un revêtement céramique.

5. Procédé suivant la revendication 4,
**caractérisé en ce que** le revêtement céramique est une couche calorifuge.
